# EUROPEAN PATENT APPLICATION

(11) **EP 1 693 192 A1**
(43) Date of publication of application: **23.08.2006**
(21) Application number: 04801684.4
(22) Date of filing: 07.12.2004
(51) Int. Cl.: B32B 15/08

(54) **COATED METAL PLATE WITH EXCELLENT CORROSION RESISTANCE AND REDUCED ENVIRONMENTAL IMPACT**

(30) Priority: 08.12.2003 JP 2003408918
(71) Applicant: NIPPON STEEL CORPORATION, Tokyo 100-71 (JP)
(72) Inventor: NOMURA, Hiromasa, NIPPON STEEL CORPORATION, Futtsu-shi, Chiba 2938511 (JP); KANAI, Hiroshi, NIPPON STEEL CORPORATION, Futtsu-shi, Chiba 2938511 (JP); TANAKA, Koki, NIPPON STEEL CORPORATION, Futtsu-shi, Chiba 2938511 (JP); SHOJI, Hiromasa, NIPPON STEEL CORPORATION, Futtsu-shi, Chiba 2938511 (JP)
(74) Representative: Vossius & Partner
(86) International application number: PCT/JP2004/018538
(87) International publication number: WO 2005/053949

(57) **Abstract**

The present invention provides a chromate-free coated metal sheet excellent in corrosion resistance and coating material adhesion and having little affect on environment. The precoated metal sheet of the invention is a coated metal sheet comprising a metal sheet having on at least one surface thereof a film mainly comprising one or both of a metal oxide and a metal hydroxide each using a metal species exclusive of chromium, the precoated metal sheet having one or both of cracks in the film and pits on the underlying sheet and having an organic coat layer on the film.

## Description

### Technical Field

The present invention relates to a precoated metal sheet and, more specifically, to a precoated metal sheet excellent in coating material adhesion and corrosion resistance, friendly to the global environment by virtue of not containing hexavalent chromium, which is considered to have a large affect on environment, and suitable for use in automobiles, building materials and home appliances.

### Background Art

Many of the metal sheets used for home appliances, building materials and automobiles are precoated for the purpose of enhancing the design properties and corrosion resistance. For such a metal sheet, a chemical conversion treatment, called a chromate treatment, is applied as a pretreatment to coating in many cases, because the chromate-treatment provides excellent corrosion resistance owing to the self-repairing function of hexavalent chromium contained in a film and excellent coating material adhesion owing to a hydrous oxide containing hexavalent chromium.

However, with recent increase in the concern for the global environment, it is required to suppress the elution of hexavalent chromium and, if possible, to not use the chromate treatment.

Against such a background, a technique using a resin chromate obtained by compounding an organic resin and chromate has been reported in JP 5-230666 A. Using this technique, the elution of hexavalent chromium can indeed be decreased but cannot be completely prevented.

On the other hand, various chromate-free treatments having a performance comparable to the chromate treatment have been recently developed. A representative example thereof is a technique of covering the metal surface with an organic resin having a chelate-forming ability to intensify the bonding force between the cover film and the metal surface, to thereby improve corrosion resistance.

For example, JP 11-29724 A discloses a chromate-free treatment using an aqueous resin containing a thiocarbonyl group-containing compound and a phosphate ion and further containing a water-dispersible silica. The corrosion resistance is indeed improved to a certain extent by this chromate-free treatment, but the coating material adhesion is not necessarily satisfactory in uses where severe working is applied. JP 8-73775 A discloses an acidic surface-treating agent containing two kinds of silane coupling agents. The coating material adhesion is indeed enhanced to a certain extent by this treating agent, but the corrosion resistance is not necessarily satisfactory.

As described above, a chromate-free treatment with a coating material adhesion and a corrosion resistance at high levels has not been developed and its urgent development is being demanded.

### Disclosure of the Invention

Under these circumstances, the present invention has been made and an object of the present invention is to provide a precoated metal sheet excellent in coating material adhesion and corrosion resistance, free from hexavalent chromium and having little affect on the environment.

As a result of intensive investigations to solve the above-described problems, the present inventors have found that when providing, on at least one surface of a metal sheet, a film mainly comprising one or both of a metal oxide and a metal hydroxide and having, as physical configuration, one or both of film cracks and metal sheet surface pits, a precoated metal sheet exhibits coating material adhesion and corrosion resistance equal to those of the chromate treated metal sheet. The present invention has been accomplished based on this finding.

That is, the gist of the present invention is as follows.
(1) A precoated metal sheet with excellent corrosion resistance and little affect on the environment, comprising a metal sheet having on at least one surface thereof an inorganic film and an organic coat layer thereon, wherein the inorganic film is a film mainly comprising one or both of a metal oxide and a metal hydroxide each using a metal species exclusive of chromium and the film has cracks therein.
(2) A precoated metal sheet with excellent corrosion resistance and little affect on environment, comprising a metal sheet on the surface of which pits are formed, the metal sheet having on at least one surface thereof an inorganic film and an organic coat layer thereon, wherein the inorganic film is a film mainly comprising one or both of a metal oxide and a metal hydroxide each using a metal species exclusive of chromium.
(3) A precoated metal sheet with excellent corrosion resistance and little affect on environment, comprising a metal sheet on the surface of which pits are formed, the metal sheet having on at least one surface thereof an inorganic film and an organic coat layer thereon, wherein the inorganic film is a film mainly comprising one or both of a metal oxide and a metal hydroxide each using a metal species exclusive of chromium and the film has cracks therein.
(4) The precoated metal sheet as described in (1) or (3), wherein the crack has a size such that the width is from 0.1 to 10 µm, the depth is from 0.5 to 10 µm and the length is 3 µm or more.
(5) The precoated metal sheet as described in (2) or (3), wherein the pit has a size such that the minor axis is from 0.5 to 10 µm and the depth is from 0.5 to 10 µm.
(6) The precoated metal sheet as described in any one of (1) to (5), wherein the metal species constituting the metal oxide or metal hydroxide is one or more member selected from titanium, zirconium and silicon.

According to the present invention, a precoated metal sheet excellent in coating material adhesion and corrosion resistance and having little affect on environment can be provided without using a chromate containing hexavalent chromium.

### Best Mode for Carrying Out the Invention

The present invention will now be described in detail.

The metal sheet for use in the present invention has on a surface thereof a film comprising, as a main component, one or both of a metal oxide and a metal hydroxide each using a metal species exclusive of chromium and has either cracks in the film or pits on the underlying metal sheet, or both.

In general, it is well known that when a metal sheet has on a surface thereof one or both of a metal oxide and a metal hydroxide as a main component, the coating material adhesion and the corrosion resistance after coating are somewhat enhanced as compared with the case of not applying such a treatment at all. As for the mechanism thereof, it is explained that the metal oxide or metal hydroxide forms strong bonding with the organic resin coated thereon and this brings about the above-described enhancement.

As a result of extensive studies, the present inventors have further found that when cracks are formed in the film of the metal oxide or metal hydroxide on the surface of a metal sheet, the coating material adhesion and corrosion resistance are more enhanced and this effect is comparable to that of the chromate treatment. The mechanism thereof is not clearly known, but it is considered that a coating material intrudes into cracks to cause a so-called anchor effect, thereby enhancing the coating material adhesion, and by virtue of the enhanced adhesion of coating material, corrosive factors are prevented from invading into the interface between the coating film and the metal oxide or metal hydroxide, resulting in the enhanced corrosion resistance.

The cracks preferably have a size such that the width is from 0.1 to 10 µm, the depth is from 0.5 to 10 µm and the length is 3 µm or more. If the width is less than 0.1 µm, the depth is less than 0.5 µm or the length is less than 3 µm, the coating material adhesion and the corrosion resistance are somewhat inferior. The presence of a large number of large cracks having a width exceeding 10 µm or a depth exceeding 10 µm is not preferred, because a phenomenon that air remaining inside the crack escapes from the coating film surface while undergoing volume expansion at the baking of coating material occurs, which may cause a rough coating film surface. With respect to the length of the crack, the larger the length, the higher the effect of enhancing adhesion. The size of the crack is more preferably such that the width is from 0.3 to 10 µm, the depth is from 1 to 10 µm and the length is 4 µm or more.

Similarly, it has been found that when a metal sheet having on a surface thereof one or both of a metal oxide and a metal hydroxide as a main component has pits, the coating material adhesion and corrosion resistance are also enhanced. The mechanism thereof is not clearly known, but it is considered that similarly to cracks in the film of the metal oxide or metal hydroxide, the coating material intrudes into the pit portion to cause a so-called anchor effect, thereby enhancing the coating material adhesion, and corrosive factors are prevented from invading into the interface between the coating film and the metal oxide or metal hydroxide, resulting in the enhanced corrosion resistance. The pit preferably has a size such that the minor axis is from 0.5 to 10 µm and the depth is from 0.5 to 10 µm. If the minor axis is less than 0.5 µm or the depth is less than 0.5 µm, the coating material adhesion and corrosion resistance are somewhat inferior. On the other hand, the presence of a large number of large pits having a minor axis exceeding 10 µm or a depth exceeding 10 µm is not preferred, because a phenomenon that air remaining inside the pit undergoes volume expansion at the baking of coating material and escapes from the coating film surface occurs, which may cause a rough coating film surface. The size of the pit is more preferably such that the minor axis is from 1 to 10 µm and the depth is from 1 to 10 µm. With respect to the major axis, the larger the major axis, the effect of enhancing the adhesion is higher.

Furthermore, when an inorganic film comprising one or both of a metal oxide and a metal hydroxide and having cracks is present on a metal sheet having surface pits formed thereon, the metal sheet exhibits more excellent coating material adhesion and corrosion resistance than in the case of having, as physical configuration, pits alone or cracks alone. The mechanism thereof is not clearly known, but it is considered that by virtue of a synergistic anchor effect by both pits and cracks, the coating material adhesion is improved, corrosive factors are prevented from invasion into the interface between the coating film and the metal oxide or metal hydroxide, and the corrosion resistance is enhanced.

The metal species constituting the metal oxide or metal hydroxide, exclusive of chromium, as the metal species for the coating film provided on the metal sheet of the present invention, is not particularly limited, but examples thereof include iron, magnesium, niobium, tantalum, aluminum, nickel, cobalt, titanium, zirconium and silicon. One of these metal species may be used alone or two or more thereof may be used in a mixed state. Among these metals, particularly preferred are titanium, zirconium and silicon. This is because the oxide or hydroxide of titanium, zirconium or silicon forms good bonding with an organic material.

The method of forming one or both of a metal oxide and a metal hydroxide each using a metal species exclusive of chromium on the metal sheet is not particularly limited and a commonly known method can be used. Examples thereof include a liquid phase deposition process using a fluoride ion, such as a fluoro-complex ion of metal, a vapor phase deposition process such as sputtering or CVD, and a plating process such as displacement plating, electroless plating, electroplating or hot-dip plating.

The method of forming cracks on the surface of the metal oxide or metal hydroxide formed on the metal sheet surface is not particularly limited, but examples thereof include mechanical grinding by abrasive paper or the like, heat shock such as quenching, and chemical etching with an acidic aqueous solution, an alkaline aqueous solution or fluoride ion-containing aqueous solution.

The method of forming pits on the surface of a metal sheet is not particularly limited, but examples thereof include mechanical grinding by abrasive paper or the like, chemical etching with an acidic or alkaline aqueous solution, and chemical etching with fluoride ions.

The metal sheet which can be used in the present invention is not particularly limited but, for example, a stainless steel sheet, an aluminum alloy sheet and a plated metal sheet are suitable. Examples of the stainless steel sheet include ferrite stainless steel sheet, martensite stainless steel sheet and austenite stainless steel sheet. Examples of the aluminum alloy sheet include JIS 1000 series (pure Al type), JIS 2000 series (Al-Cu type), JIS 3000 series (Al-Mn type), JIS 4000 series (Al-Si type), JIS 5000 series (Al-Mg type), JIS 6000 series (Al-Mg-Si type) and JIS 7000 series (Al-Zn type). Examples of the plated steel sheet include Zn-plated steel sheet, Zn-Fe alloy-plated steel sheet, Zn-Ni alloy-plated steel sheet, Zn-Al alloy-plated steel sheet, Zn-Al-Mg alloy-plated steel sheet, Zn-Al-Mg-Si alloy-plated steel sheet, Al-Si alloy-plated steel sheet and Al-Zn-Si alloy-plated steel sheet.

A particularly preferred metal sheet is an alloy-plated steel sheet mainly comprising Zn or Al. Usually, an electrochemically base portion and an electrochemically noble portion are present on the surface of an alloy-plated steel sheet. When a metal oxide or metal hydroxide is grown on such a plated steel sheet by a liquid phase process, for example, by using an acidic or alkaline aqueous solution or a fluoride ion-containing aqueous solution, the electrochemically base portion dissolves and the noble portion remains without dissolving. As a result, pits are first formed on the underlying plating, and at the same time, cracks are formed in the metal oxide or metal hydroxide growing on the plating.

For example, in the case of a hot-dip 55% Al-43.4% Zn-1.6% Si alloy-plated steel sheet, the Zn-rich phase is the base portion and the Al-rich phase is the noble portion. When this plated metal sheet is treated with metal-hexafluoro complex ion, the Zn-rich phase is selectively dissolved to form pits and the Al-rich phase remains almost as-is. Then, a metal oxide or metal hydroxide grows mainly on the Al-rich phase, whereas cracks are generated in the metal oxide or metal hydroxide on the Zn-rich phase. The same phenomenon occurs in a plated steel sheet containing Zn or Al as a main component, such as hot-dip Zn-5% Al-0.1% Mg alloy-plated steel sheet, hot-dip Zn-11% Al-3% Mg-0.2% Si alloy-plated steel sheet and hot-dip Al-9% Si alloy-plated steel sheet. In this case, even when the underlying steel sheet is not a soft steel but is a stainless steel sheet, the same phenomenon is observed. Examples of the stainless steel sheet include hot-dip Al-9% Si alloy-plated stainless steel sheet.

The above-described reaction may be performed by a liquid phase process through simple dipping, but the growth of the oxide or hydroxide on the metal sheet surface to be treated may be accelerated by short-circuit to a metal having a standard electrode potential lower than that of the metal sheet to be treated. Furthermore, by electrically connecting an insoluble material to the metal sheet to be treated, the system may be controlled such that the insoluble material causes an anode reaction and the metal sheet causes a cathode reaction.

The coating material for the precoated metal sheet of the present invention is not particularly limited and a coating material usually used for precoated metal sheets can be used as-is. As for the resin, commonly known resins may be used according to usage. More specifically, examples thereof include those where a resin component such as high molecular polyester-based resin, polyester-based resin, acryl-based resin, epoxy-based resin, urethane-based resin, fluorine-based resin, silicon polyester-based resin, polyester urethane resin, vinyl chloride-based resin, polyolefin-based resin, butyral-based resin, polycarbonate-based resin, phenol-based resin or a modified resin thereof is crosslinked by a crosslinking agent component such as butylated melamine, methylated melamine, butyl methyl-mixed melamine, urea resin, isocyanate or a mixture thereof, and also include electron beam-curable resins and ultraviolet-curable resins.

The coating material for the precoated metal sheet of the present invention may contain a coloring pigment or dye or a gloss-adjusting agent such as silica and also, if desired, may contain a surface smoothing agent, an ultraviolet absorbent, a hindered amine-based photostabilizer, a viscosity adjusting agent, a curing catalyst, a pigment dispersant, a pigment precipitation inhibitor, a color separation inhibitor and the like.

For the purpose of enhancing the corrosion resistance, the coating may comprise two or more layers. The undercoat coating may contain a rust-preventive pigment. As for the rust-preventive pigment, known rust-preventive pigments can be used and examples of the rust-preventive pigment which can be used include phosphoric acid-based rust-preventive pigments such as zinc phosphate, iron phosphate, aluminum phosphate and zinc phosphite, molybdic acid-based rust-preventive pigments such as calcium molybdate, aluminum molybdate and barium molybdate, vanadium-based rust-preventive pigments such as vanadium oxide, ion-exchangeable silica-based rust-preventive pigments such as calcium ion-exchangeable silica, chromate-based rust-preventive pigments such as strontium chromate, zinc chromate, calcium chromate, potassium chromate and barium chromate, fine particulate silicas such as water-dispersed silica and fumed silica, and ferroalloys such as ferrosilicon. These may be used individually or as a mixture of multiple species. Furthermore, a carbon black powder may also be added. Incidentally, in order to further reduce the affect on environment, use of a chromate-based rust-preventive pigment is preferably avoided.

### Examples

The present invention will now be described in greater detail below by referring to Examples, but the present invention is not limited to these Examples.

The metal sheets used were a hot-dip 55% Al-43.4% Zn-1.6% Si alloy-plated steel sheet (plating coverage on both surfaces: 150 g/m²), a Zn-11% Al-3% Mg-0.2% Si alloy-plated steel sheet (plating coverage on both surfaces: 120 g/m²), a stainless steel sheet (SUS304) and an aluminum alloy sheet (JIS A 3005 (Al-Mn type)). These metal sheets all had a thickness of 0.8 mm. Each metal sheet sample was subjected to an alkali degreasing treatment (with "SURFCLEANER 155", produced by Nippon Paint Co., Ltd.) and then to the tests.

For imparting a metal oxide or a metal hydroxide to the metal sheet, a liquid phase process or a vapor phase process was used.

The treating solutions used in the liquid phase process were an aqueous 0.1 mol/L ammonium hexafluorosilicate solution, an aqueous 0.1 mol/L ammonium hexafluorotitanate solution, an aqueous 0.1 mol/L ammonium hexafluorozirconate solution, a mixed aqueous solution of an aqueous 0.05 mol/L ammonium hexafluorotitanate solution and an aqueous 0.05 mol/L ammonium hexafluorosilicate solution (Mixed Solution A), a mixed aqueous solution of an aqueous 0.05 mol/L ammonium hexafluorotitanate solution and an aqueous 0.05 mol/L ammonium hexafluorozirconate solution (Mixed Solution B), a mixed aqueous solution of an aqueous 0.05 mol/L ammonium hexafluorozirconate solution and an aqueous 0.05 mol/L ammonium hexafluorosilicate solution (Mixed Solution C), and a mixed aqueous solution of an aqueous 0.03 mol/L ammonium hexafluorotitanate solution, an aqueous 0.03 mol/L ammonium hexafluorosilicate solution and an aqueous 0.03 mol/L ammonium hexafluorozirconate solution (Mixed Solution D).

Each metal sheet after degreasing was dipped in the treating solution and treated under the following conditions to form a film of metal oxide or metal hydroxide.
(a) Film formation of metal oxide or metal hydroxide by simple dipping
   The film formation was performed at room temperature for 10 minutes and after the film formation, the metal sheet was washed with water and dried.
(b) Film formation of metal oxide or metal hydroxide by cathodic electrolysis using platinum as the counter electrode

The film formation was performed at room temperature for 5 minutes by controlling the current density to 100 mA/cm² and, after the film formation, the metal sheet was washed with water and dried.

In the vapor phase process, the metal sheet was treated by sputtering using Si, Ti or Zr as a target to form a film of metal oxide or metal hydroxide on the substrate of metal sheet.

Each film formed by the liquid phase process or vapor phase process was subjected to analyses by X-ray photoelectric spectroscopy and infrared spectroscopy to confirm the production of a metal oxide or a metal hydroxide.

Each metal sheet having formed thereon a metal oxide film or a metal hydroxide film was coated under the following conditions to obtain a precoated metal sheet. First, a modified epoxy-based primer precoating material (78 Primer, produced by Kawakami Toryo K.K.), as a chromete-free rust-preventive pigment, which contains a total of 30% by weight of 1:1 mixture of calcium ion-exchangeable silica (Shildex C303, manufactured by Grace) and aluminum dihydrogen tripolyphosphate (Al₂H₂P₃O₁₀·2H₂O) (K-WHITE #105, manufactured by Tayaca), was coated as a primer coating material to give a dry thickness of 5 µm and further thereon, a polyester urethane-based coating material (570T, produced by Kawakami Toryo K.K.) was applied to give a dry thickness of 15 µm.

These precoated metal sheets were evaluated regarding coating material adhesion and corrosion resistance under the following conditions.

### 1) Coating Material Adhesion

The precoated metal sheet produced by the above-described method was dipped in boiling water for 60 minutes. Thereafter, crosscuts were formed thereon according to the crosscut test method described in JIS K 5400 and further an Erichsen process yielding an Erichsen value of 7 mm was applied. A pressure-sensitive adhesive tape (cellophane tape produced by Nichiban Co., Ltd.) was attached to the worked part and then swiftly peeled off by pulling it in an oblique direction of 45°, and the number of peeled crosscuts out of 100 crosscuts was counted. The adhesion was evaluated on a 5-stage scale according to the degree of peeling. Samples having a score of 3 or more were ranked as "passed".

**Table 1: Score of Coating Material Adhesion**

| Score | Rating Criteria |
|---|---|
| 5 | No peeling |
| 4 | Peeled area ratio of less than 5% |
| 3 | Peeled area ratio of 5% to less than 20% |
| 2 | Peeled area ratio of 20% to less than 70% |
| 1 | Peeled area ratio of 70% or more |

### 2) Corrosion Resistance Test

Samples for corrosion resistance test were prepared by cutting the precoated metal sheet in such a manner that they have a cut end with an upward flash and a cut end with a downward flash. According to the neutral salt spray cycle test (spraying of an aqueous 5 wt% NaCl solution (2 hours) → drying (60°C, RH: 20 to 30%, 4 hours) → wetting (50°C, RH: 95% or more)) described in JIS H 8502, a 180-cycle test was performed. The maximum blister width from the cut end was evaluated. The samples were rated on a 5-stage scale according to the blister width and samples having a score of 3 or more were ranked as "passed".

**Table 2: Score of Corrosion Resistance**

| Score | Rating Criteria |
|---|---|
| 5 | No blister |
| 4 | Maximum blister width of 3 mm or less |
| 3 | Maximum blister width of more than 3 mm to 5 mm |
| 2 | Maximum blister width of more than 5 mm to 7 mm |
| 1 | Maximum blister width of more than 7 mm |

Samples passed both the coating material adhesion test and the corrosion resistance test were comprehensively judged as "passed".

The results obtained are shown in Tables 3 to 6. The width, depth, length and minor axis of cracks and pits were determined as an average of 5 cracks or pits by observing a representative portion from the surface or cross-section of a sample through a scanning electron microscope.

When the outer appearance after the film formation of metal oxide or metal hydroxide was observed through a scanning electron microscope, in the case of treating 55% Al-43.4% Zn-1.6% Si alloy-plated steel sheet and Zn-11% Al-3% Mg-0.2% Si alloy-plated steel sheet by the liquid phase process, pits were formed on the underlying metal sheet after the stage of treatment and cracks were generated in the formed metal oxide or metal hydroxide film. On the other hand, in the case of aluminum alloy sheet and stainless steel sheet, even when treated by the liquid phase process, neither pits nor cracks were formed.

When treated by the vapor phase process (sputtering), neither pits nor cracks were generated in any underlying metal sheet condition or in any metal oxide or metal hydroxide condition.

As for specimens unable to form either cracks or pits at the film-formation stage, those where the surface of the formed metal oxide or metal hydroxide film was lightly rubbed with a diamond paste to artificially produce cracks, and those where the surface of the underlying metal sheet before film formation was lightly rubbed to artificially form pits were also evaluated.

**Table 3: Examples of underlying metal sheets of 55% Al-43.4% Zn-1.6% Si alloy-plated steel**

| No. | Treating Solution (liquid phase process) or Target (vapor phase process) | Treating Method | Crack | | Pit | | Corrosion Resistance | Adhesion | Overall Judgement | Remarks |
|---|---|---|---|---|---|---|---|---|---|---|
| | | | width/ µm | length/ µm | minor axis/µm | depth/ µm | | | | |
| 1 | ammonium hexafluorosilicate | simple dipping | 1 | 4 | 1 | 2 | 4 | 3 | passed | Invention |
| 2 | ammonium hexafluorosilicate | cathodic electrolysis | 2 | 4 | 2 | 3 | 4 | 3 | passed | Invention |
| 3 | ammonium hexafluorotitanate | simple dipping | 1 | 5 | 1 | 2 | 4 | 4 | passed | Invention |
| 4 | ammonium hexafluorotitanate | cathodic electrolysis | 1 | 8 | 1 | 3 | 4 | 4 | passed | Invention |
| 5 | ammonium hexafluorozirconate | simple dipping | 2 | 5 | 1 | 2 | 4 | 3 | passed | Invention |
| 6 | ammonium hexafluorozirconate | cathodic electrolysis | 1 | 6 | 1 | 3 | 4 | 3 | passed | Invention |
| 7 | Mixed Solution A | simple dipping | 1 | 4 | 1 | 2 | 4 | 3 | passed | Invention |
| 8 | Mixed Solution A | cathodic electrolysis | 2 | 6 | 1 | 2 | 4 | 3 | passed | Invention |
| 9 | Mixed Solution B | simple dipping | 1 | 4 | 1 | 2 | 4 | 3 | passed | Invention |
| 10 | Mixed Solution B | cathodic electrolysis | 2 | 7 | 1 | 2 | 4 | 3 | passed | Invention |
| 11 | Mixed Solution C | simple dipping | 1 | 4 | 1 | 2 | 4 | 3 | passed | Invention |
| 12 | Mixed Solution C | cathodic electrolysis | 1 | 4 | 1 | 2 | 4 | 3 | passed | Invention |
| 13 | Mixed Solution D | simple dipping | 1 | 3 | 1 | 2 | 4 | 3 | passed | Invention |
| 14 | Mixed Solution D | cathodic electrolysis | 1 | 3 | 1 | 2 | 4 | 3 | passed | Invention |
| 15 | Si | sputtering→polishing¹⁾ | 3 | 55 | 0 | 0 | 3 | 3 | passed | Invention |
| 16 | Si | polishing→sputtering²⁾ | 0 | 0 | 8 | 5 | 3 | 3 | passed | Invention |
| 17 | Si | sputtering | 0 | 0 | 0 | 0 | 2 | 2 | not passed | Comparative |
| 18 | Ti | sputtering→polishing¹⁾ | 2 | 60 | 0 | 0 | 3 | 3 | passed | Invention |
| 19 | Ti | polishing→sputtering²⁾ | 0 | 0 | 3 | 7 | 3 | 3 | passed | Invention |
| 20 | Ti | sputtering | 0 | 0 | 0 | 0 | 2 | 2 | not passed | Comparative |
| 21 | Zr | sputtering→polishing¹⁾ | 7 | 40 | 0 | 0 | 3 | 3 | passed | Invention |
| 22 | Zr | polishing→sputtering²⁾ | 0 | 0 | 5 | 8 | 3 | 3 | passed | Invention |
| 23 | Zr | sputtering | 0 | 0 | 0 | 0 | 2 | 2 | not passed | Comparative |

| | | | | | | | | | | |
|---|---|---|---|---|---|---|---|---|---|---|
| 1) The film was formed by sputtering and then polished with a diamond paste. | | | | | | | | | | |
| 2) The underlying metal sheet was polished with a diamond paste and then the film was formed by sputtering. | | | | | | | | | | |

**Table 4: Examples of underlying metal sheets of Zn-11% Al-3% Mg-0.2% Si alloy-plated steel**

| No. | Treating Solution (liquid phase process) or Target (vapor phase process) | Treating Method | Crack | | Pit | | Corrosion Resistance | Adhesion | Overall Judgement | Remarks |
|---|---|---|---|---|---|---|---|---|---|---|
| | | | width/ µm | length/ µm | minor axis/µm | depth/ µm | | | | |
| 1 | ammonium hexafluorosilicate | simple dipping | 2 | 5 | 1 | 3 | 4 | 3 | passed | Invention |
| 2 | ammonium hexafluorosilicate | cathodic electrolysis | 2 | 6 | 2 | 4 | 4 | 3 | passed | Invention |
| 3 | ammonium hexafluorotitanate | simple dipping | 2 | 7 | 1 | 2 | 4 | 4 | passed | Invention |
| 4 | ammonium hexafluorotitanate | cathodic electrolysis | 3 | 9 | 2 | 5 | 4 | 4 | passed | Invention |
| 5 | ammonium hexafluorozirconate | simple dipping | 2 | 7 | 1 | 3 | 4 | 3 | passed | Invention |
| 6 | ammonium hexafluorozirconate | cathodic electrolysis | 3 | 10 | 2 | 4 | 4 | 3 | passed | Invention |
| 7 | Mixed Solution A | simple dipping | 2 | 9 | 1 | 2 | 4 | 3 | passed | Invention |
| 8 | Mixed Solution A | cathodic electrolysis | 2 | 8 | 1 | 3 | 4 | 3 | passed | Invention |
| 9 | Mixed Solution B | simple dipping | 1 | 4 | 1 | 2 | 4 | 3 | passed | Invention |
| 10 | Mixed Solution B | cathodic electrolysis | 2 | 8 | 1 | 3 | 4 | 3 | passed | Invention |
| 11 | Mixed Solution C | simple dipping | 3 | 6 | 1 | 2 | 4 | 3 | passed | Invention |
| 12 | Mixed Solution C | cathodic electrolysis | 1 | 4 | 1 | 3 | 4 | 3 | passed | Invention |
| 13 | Mixed Solution D | simple dipping | 1 | 5 | 1 | 2 | 4 | 3 | passed | Invention |
| 14 | Mixed Solution D | cathodic electrolysis | 1 | 3 | 1 | 2 | 4 | 3 | passed | Invention |
| 15 | Si | sputtering→polishing¹⁾ | 5 | 60 | 0 | 0 | 3 | 3 | passed | Invention |
| 16 | Si | polishing→sputtering²⁾ | 0 | 0 | 5 | 7 | 3 | 3 | passed | Invention |
| 17 | Si | sputtering | 0 | 0 | 0 | 0 | 2 | 2 | not passed | Comparative |
| 18 | Ti | sputtering→polishing¹⁾ | 3 | 75 | 0 | 0 | 3 | 3 | passed | Invention |
| 19 | Ti | polishing→sputtering²⁾ | 0 | 0 | 3 | 8 | 3 | 3 | passed | Invention |
| 20 | Ti | sputtering | 0 | 0 | 0 | 0 | 2 | 2 | not passed | Comparative |
| 21 | Zr | sputtering→polishing¹⁾ | 8 | 52 | 0 | 0 | 3 | 3 | passed | Invention |
| 22 | Zr | polishing→sputtering²⁾ | 0 | 0 | 6 | 8 | 3 | 3 | passed | Invention |
| 23 | Zr | sputtering | 0 | 0 | 0 | 0 | 2 | 2 | not passed | Comparative |

| | | | | | | | | | | |
|---|---|---|---|---|---|---|---|---|---|---|
| 1) The film was formed by sputtering and then polished with a diamond paste. | | | | | | | | | | |
| 2) The underlying metal sheet was polished with a diamond paste and then the film was formed by sputtering. | | | | | | | | | | |

**Table 5: Examples of underlying metal sheets of stainless steel (SUS304)**

| No. | Treating Solution (liquid phase process) or Target (vapor phase process) | Treating Method | Crack | | Pit | | Corrosion Resistance | Adhesion | Overall Judgement | Remarks |
|---|---|---|---|---|---|---|---|---|---|---|
| | | | width/ µm | length/ µm | minor axis/µm | depth/ µm | | | | |
| 1 | ammonium hexafluorosilicate | simple dipping | 0 | 0 | 0 | 0 | 2 | 2 | not passed | Comparative |
| 2 | ammonium hexafluorosilicate | simple dipping →polishing³⁾ | 5 | 70 | 0 | 0 | 3 | 3 | passed | Invention |
| 3 | ammonium hexafluorosilicate | cathodic electrolysis | 0 | 0 | 0 | 0 | 2 | 2 | not passed | Comparative |
| 4 | ammonium hexafluorosilicate | cathodic electrolysis →polishing³⁾ | 8 | 65 | 0 | 0 | 3 | 3 | passed | Invention |
| 5 | ammonium hexafluorotitanate | simple dipping | 0 | 0 | 0 | 0 | 2 | 2 | not passed | Comparative |
| 6 | ammonium hexafluorotitanate | simple dipping →Polishing³⁾ | 10 | 70 | 0 | 0 | 3 | 3 | passed | Invention |
| 7 | ammonium hexafluorotitanate | cathodic electrolysis | 0 | 0 | 0 | 0 | 2 | 2 | not passed | Comparative |
| 8 | ammonium hexafluorotitanate | cathodic electrolysis →polishing³⁾ | 8 | 55 | 0 | 0 | 3 | 3 | passed | Invention |
| 9 | ammonium hexafluorozirconate | simple dipping | 0 | 0 | 0 | 0 | 2 | 2 | not passed | Comparative |
| 10 | ammonium hexafluorozirconate | simple dipping →Polishing³⁾ | 6 | 80 | 0 | 0 | 3 | 3 | passed | Invention |
| 11 | ammonium hexafluorozirconate | cathodic electrolysis | 0 | 0 | 0 | 0 | 2 | 2 | not passed | Comparative |
| 12 | ammonium hexafluorozirconate | cathodic electrolysis →polishing³⁾ | 0 | 0 | 0 | 0 | 3 | 3 | passed | Invention |
| 13 | Si | sputtering | 0 | 0 | 0 | 0 | 2 | 2 | not passed | Comparative |
| 14 | Si | sputtering→polishing¹⁾ | 3 | 52 | 0 | 0 | 3 | 3 | passed | Invention |
| 15 | Si | polishing→sputtering²⁾ | 0 | 0 | 3 | 5 | 3 | 3 | passed | Invention |
| 16 | Si | sputtering | 0 | 0 | 0 | 0 | 2 | 2 | not passed | Comparative |
| 17 | Ti | sputtering→polishing¹⁾ | 4 | 45 | 0 | 0 | 3 | 3 | passed | Invention |
| 18 | Ti | polishing→sputtering²⁾ | 0 | 0 | 2 | 5 | 3 | 3 | passed | Invention |
| 19 | Ti | sputtering | 0 | 0 | 0 | 0 | 2 | 2 | not passed | Comparative |
| 20 | Zr | sputtering→polishing¹⁾ | 3 | 40 | 0 | 0 | 3 | 3 | passed | Invention |
| 21 | Zr ' | polishing→sputtering²⁾ | 0 | 0 | 4 | 7 | 3 | 3 | passed | Invention |
| 22 | Zr | sputtering | 0 | 0 | 0 | 0 | 2 | 2 | not passed | Comparative |

| | | | | | | | | | | |
|---|---|---|---|---|---|---|---|---|---|---|
| 1) The film was formed by sputtering and then polished with a diamond paste. | | | | | | | | | | |
| 2) The underlying metal sheet was polished with a diamond paste and then the film was formed by sputtering. | | | | | | | | | | |
| 3) The film was formed by the liquid phase process and then polished with a diamond paste. | | | | | | | | | | |

**Table 6: Examples of underlying metal sheets of aluminum alloy (JIS A 3005)**

| No. | Treating Solution (liquid phase process) or Target (vapor phase process) | Treating Method | Crack | | Pit | | Corrosion Resistance | Adhesion | Overall Judgement | Remarks |
|---|---|---|---|---|---|---|---|---|---|---|
| | | | width/ µm | length/ µm | minor axis/µm | depth/ µm | | | | |
| 1 | ammonium hexafluorosilicate | simple dipping | 0 | 0 | 0 | 0 | 2 | 2 | not passed | Comparative |
| 2 | ammonium hexafluorosilicate | simple dipping →Polishing³⁾ | 8 | 55 | 0 | 0 | 3 | 3 | passed | Invention |
| 3 | ammonium hexafluorosilicate | cathodic electrolysis | 0 | 0 | 0 | 0 | 2 | 2 | not passed | Comparative |
| 4 | ammonium hexafluorosilicate | cathodic electrolysis →polishing³⁾ | 6 | 80 | 0 | 0 | 3 | 3 | passed | Invention |
| 5 | ammonium hexafluorotitanate | simple dipping | 0 | 0 | 0 | 0 | 2 | 2 | not passed | Comparative |
| 6 | ammonium hexafluorotitanate | simple dipping →Polishing³⁾ | 6 | 80 | 0 | 0 | 3 | 3 | passed | Invention |
| 7 | ammonium hexafluorotitanate | cathodic electrolysis | 0 | 0 | 0 | 0 | 2 | 2 | not passed | Comparative |
| 8 | ammonium hexafluorotitanate | cathodic electrolysis →polishing³⁾ | 8 | 60 | 0 | 0 | 3 | 3 | passed | Invention |
| 9 | ammonium hexafluorozirconate | simple dipping | 0 | 0 | 0 | 0 | 2 | 2 | not passed | Comparative |
| 10 | ammonium hexafluorozirconate | simple dipping →Polishing³⁾ | 4 | 55 | 0 | 0 | 3 | 3 | passed | Invention |
| 11 | ammonium hexafluorozirconate | cathodic electrolysis | 0 | 0 | 0 | 0 | 2 | 2 | not passed | Comparative |
| 12 | ammonium hexafluorozirconate | cathodic electrolysis →polishing³⁾ | 0 | 0 | 0 | 0 | 3 | 3 | passed | Invention |
| 13 | Si | sputtering | 0 | 0 | 0 | 0 | 2 | 2 | not passed | Comparative |
| 14 | Si | sputtering→polishing¹⁾ | 5 | 70 | 0 | 0 | 3 | 3 | passed | Invention |
| 15 | Si | polishing→sputtering²⁾ | 0 | 0 | 4 | 6 | 3 | 3 | passed | Invention |
| 16 | Si | sputtering | 0 | 0 | 0 | 0 | 2 | 2 | not passed | Comparative |
| 17 | Ti | sputtering→polishing¹⁾ | 5 | 80 | 0 | 0 | 3 | 3 | passed | Invention |
| 18 | Ti | polishing→sputtering²⁾ | 0 | 0 | 4 | 7 | 3 | 3 | passed | Invention |
| 19 | Ti | sputtering | 0 | 0 | 0 | 0 | 2 | 2 | not passed | Comparative |
| 20 | Zr | sputtering→polishing¹⁾ | 4 | 40 | 0 | 0 | 3 | 3 | passed | Invention |
| 21 | Zr | polishing→sputtering²⁾ | 0 | 0 | 3 | 5 | 3 | 3 | passed | Invention |
| 22 | Zr | sputtering | 0 | 0 | 0 | 0 | 2 | 2 | not passed | Comparative |

| | | | | | | | | | | |
|---|---|---|---|---|---|---|---|---|---|---|
| 1) The film was formed by sputtering and then polished with a diamond paste. | | | | | | | | | | |
| 2) The underlying metal sheet was polished with a diamond paste and then the film was formed by sputtering. | | | | | | | | | | |
| 3) The film was formed by the liquid phase process and then polished with a diamond paste. | | | | | | | | | | |

As seen from Tables 3 to 6, the coating material adhesion and corrosion resistance are good under conditions, within the scope of the invention, of a metal oxide or metal hydroxide having cracks and a metal sheet having pits. Particularly, when 55% Al-43.4% Zn-1.6% Si alloy-plated steel sheet and Zn-11% Al-3% Mg-0.2% Si alloy-plated steel sheet are used as the underlying metal sheets and treated by a liquid phase process, as shown in Tables 3 and 4, the cracks and pits are simultaneously formed, which is effective.

On the other hand, when the film is formed by a vapor phase process such as sputtering or when the underlying metal sheet is a stainless steel sheet or the like, pits are not formed on the underlying metal sheet and cracks are also not formed in the metal oxide or metal hydroxide film prepared. Accordingly, in such cases, the precoated metal sheet, as-is, is not satisfactory in the coating material adhesion and also in the corrosion resistance. However, both the coating material adhesion and the corrosion resistance are improved by forming cracks or pits by a physical method such as polishing with a diamond paste.

## Claims

1. A precoated metal sheet, with excellent corrosion resistance and having little affect on environment, comprising a metal sheet having, on at least one surface thereof, an inorganic film and an organic coat layer thereon, wherein said inorganic film is a film mainly comprising one or both of a metal oxide and a metal hydroxide each using a metal species exclusive of chromium and said film has cracks therein.

2. A precoated metal sheet, with excellent corrosion resistance and having little effect on environment, comprising a metal sheet on the surface of which pits are formed, the metal sheet having, on at least one surface thereof, an inorganic film and an organic coat layer thereon, wherein said inorganic film is a film mainly comprising one or both of a metal oxide and a metal hydroxide each using a metal species exclusive of chromium.

3. A precoated metal sheet, with excellent corrosion resistance and having little affect on environment, comprising a metal sheet on the surface of which pits are formed, the metal sheet having, on at least one surface thereof, an inorganic film and an organic coat layer thereon, wherein said inorganic film is a film mainly comprising one or both of a metal oxide and a metal hydroxide each using a metal species exclusive of chromium and said film has cracks therein.

4. The precoated metal sheet as claimed in claim 1 or 3, wherein said crack has a size such that the width is from 0.1 to 10 µm, the depth is from 0.5 to 10 µm and the length is 3 µm or more.

5. The precoated metal sheet as claimed in claim 2 or 3, wherein said pit has a size such that the minor axis is from 0.5 to 10 µm and the depth is from 0.5 to 10 µm.

6. The precoated metal sheet as claimed in any one of claims 1 to 5, wherein the metal species constituting said metal oxide or metal hydroxide is one or more member selected from titanium, zirconium and silicon.
